# EUROPÄISCHE PATENTANMELDUNG

(11) **EP 1 207 551 A2**
(43) Veröffentlichungstag der Anmeldung: **22.05.2002**
(21) Anmeldenummer: 01125069.3
(22) Anmeldetag: 22.10.2001
(51) Int. Cl.: H01L 21/336

(54) **Halbleiterbauelement mit einer leitfähigen Struktur und Verfahren zu seiner Herstellung**

(30) Priorität: 16.11.2000 DE 10056885
(71) Anmelder: Infineon Technologies AG, 81669 München (DE)
(72) Erfinder: Elbel, Norbert, Dr., 81825 München (DE); Lachner, Rudolf, Dr., 85051 Ingolstadt (DE); Reichert, Hansjörg, Dr., 81539 München (DE)
(74) Vertreter: Epping Hermann & Fischer

(57) **Zusammenfassung**

Die vorliegende Erfindung ist dazu geeignet ein metallisiertes Gate eines Transistors herzustellen, welches dadurch mit einem niedrigen Widerstand gebildet ist und für Hochfrequenz-Anwendungen geeignet ist. Es werden LOCOS-Gebiete (2) in einem Siliziumsubstrat (1) gebildet, die für einen nachfolgenden CMP-Schritt als Ätzstopp dienen. Durch den CMP-Schritt wird ein Oberflächenbereich (18) eines vorher gebildeten Gates (4) freigelegt. Nachfolgend wird eine metallhaltige leitfähige Struktur (9) auf dem freigelegten Oberflächenbereich (18) des Gates (4) angeordnet, wodurch ein niedriger Widerstand für die Anordnung bestehend aus Polysilizium-Gate (4) und Metalleitung (9) erreicht wird.

## Beschreibung

Die vorliegende Erfindung betrifft ein Halbleiterbauelement mit einer leitfähigen Struktur und ein Verfahren zu seiner Herstellung.

Halbleiterbauelemente werden heutzutage beispielsweise aus siliziumhaltigem Material gefertigt. Dabei werden elektrische Leiterbahnen unter anderem aus polykristallinem, dotiertem Silizium gebildet. Dotiertes Silizium weist im Vergleich zu einigen Metallen einen erheblich höheren spezifischen Widerstand auf. Für viele Anwendungen von Halbleiterbauelementen, wie beispielsweise hochfrequenztaugliche Einzelhalbleiter, ist ein niedriger Widerstand von Zuleitungen und Gate-Elektroden von entscheidender Bedeutung. So ist z.B. im Fall von Hochfrequenz-Tetroden ein niedriges Rauschen nur in Verbindung mit entsprechend niedrigen Gate-Widerständen zu erzielen. Üblicherweise werden entsprechende hochfrequenztaugliche Einzelhalbleiter mit einem metallischen Gate realisiert.

Um die Produktion von Einzelhalbleitern sinnvoll in eine bestehende CMOS-Fertigung (Complementary Metal Oxide Semiconductor) eingliedern zu können, ist es notwendig, den Fertigungsprozeß so weit wie möglich aus bestehenden CMOS-Prozeßmodulen aufzubauen. Da bei CMOS typischerweise dotiertes Polysilizium als Gate-Material verwendet wird besteht für hochfrequenztaugliche Einzelhalbleiter das technische Problem eines relativ hohen Gate-Widerstands. Dieser Widerstand liegt typischerweise um 3 bis 4 Größenordnungen über dem Widerstand metallischer Gates.

Beispielsweise kann der Gate-Widerstand mittels einer Silizierung des Gates mit Titansilizid oder Cobaltsilizid reduziert werden. Hierdurch ist beispielsweise eine Reduktion des Gate-Widerstandes um den Faktor 30 möglich. Dies reicht allerdings bei weitem noch nicht an 3 bis 4 Größenordnungen (Faktor 1000 bis 10000) heran. Nachteile der Silizierung bestehen in hohen Prozeßkosten sowie der notwendigen Blockierung der Silizierung der Source- und Drain-Gebiete, die notwendig ist, da bei Einzelhalbleitern keine I/O-Transistoren vorhanden sind, die einen elektrostatischen Durchbruch verhindern könnten.

Weiterhin ist aus dem Stand der Technik bekannt, daß ein niedriger Gate-Widerstand erreicht werden kann, indem oberhalb des Polysilizium-Gates des Transistors eine Aluminiumleiterbahn verläuft, die über beabstandete Kontaktlöcher mit dem Polysilizium-Gate verbunden ist. Der Gate-Widerstand wird in diesem Fall im wesentlichen durch den halben Abstand zwischen zwei Kontaktlöchern begrenzt. Da die Kontaktlöcher nur mit einer begrenzten lateralen Genauigkeit auf das Polysilizium-Gate justiert werden können, muß das Polysilizium-Gate an den Kontaktlöchern lokal verbreitert werden. Diese Verbreiterungen führen zu einer Erhöhung der Gate-Kapazität und einer Reduzierung der Packungsdichte des Bauelements. Dies ist nachteilig, da das Bauelement eine verringerte Flächenausnutzung aufweist. Üblicherweise gebräuchlich ist dabei ein Abstand zwischen zwei Kontaktlöchern von ca. 200µm. Bei einer Gate-Länge (entspricht Kanalweite des Transistors) von 1000µm entspricht dies einer Reduktion des Gate-Widerstandes um den Faktor 100, falls das Polysilizium-Gate nicht siliziert ist und einer Reduzierung um den Faktor 1000 falls das Polysilizium-Gate siliziert ist. Nachteilig ist dabei allerdings, daß der Aufwand zur Herstellung der Bauelemente wesentlich vergrößert ist, da zusätzlich zu dem Polysilizium-Gate eine Aluminiumleitung sowie Durchkontaktierungen hergestellt werden müssen. Weiterhin ist die Flächenausnutzung des Bauelementes verringert und das Bauelement weist durch die lokale Verbreiterung des Polysilizium-Gates an den Kontaktlöchern - im Vergleich zu dem übrigen Verlauf des Polysilizium-Gates - verlängerte Kanallängen auf, die zu einem nachteiligen elektrischen Verhalten führen.

Es ist die Aufgabe der Erfindung eine verbesserte leitfähige Struktur eines Halbleiterbauelements und ein Verfahren zu ihrer Herstellung anzugeben.

Erfindungsgemäß wird die Aufgabe gelöst durch ein Halbleiterbauelement mit einer leitfähigen Struktur, umfassend:
- ein Substrat mit einer Substratoberfläche und einem isolierenden Bereich, der eine zweite Oberfläche aufweist, wobei die Substratoberfläche gegenüber der zweiten Oberfläche zurückgesetzt ist;
- eine leitfähige Struktur, die neben dem isolierenden Bereich auf der Substratoberfläche angeordnet ist;
- eine isolierenden Schicht, die auf der Substratoberfläche angeordnet ist und die leitfähige Struktur zumindest teilweise umgibt und wobei der isolierende Bereich, die isolierende Schicht und die leitfähige Struktur eine plane Oberfläche bilden;
- eine metallhaltige leitfähigen Struktur, die auf der planen Oberfläche oberhalb der leitfähigen Struktur angeordnet ist.

Die erfindungsgemäße Lösung weist den Vorteil auf, daß ein kostengünstiges Verfahren zur Erstellung der erfindungsgemäßen Anordnung möglich ist. Weiterhin wird auf der leitfähigen Struktur, bei der es sich beispielsweise um ein Polysilizium-Gate oder eine Polysilizium-Leiterbahn handeln kann, eine metallhaltige leitfähige Struktur angeordnet, so daß die aus dem Stand der Technik bekannten nachteiligen Kontaktlöcher vermieden werden können. Da der isolierende Bereich, die isolierende Schicht und die leitfähige Struktur eine plane Oberfläche bilden, kann die metallhaltige leitfähige Struktur oberhalb der leitfähigen Struktur angeordnet werden und mit größeren lateralen Abmessungen ausgebildet werden als die leitfähige Struktur. Zusätzlich werden durch die Planarität Metallreste an Topographischen Stufen vermieden und lithographische Justierungenauigkeiten bereiten keine elektrischen Kurzschlüsse. Die leitfähige Struktur definiert z.B. eine Kanallänge eines Transistors, die für Hochfrequenz-Anwendungen relativ kurz ausgebildet wird

Mit Bezug auf das Verfahren wird die Aufgabe gelöst durch ein Verfahren zur Herstellung eines Halbleiterbauelements mit einer leitfähigen Struktur mit den Schritten:
- Bilden eines isolierenden Bereichs auf einem Substrat, wobei das Substrat eine Substratoberfläche und der isolierende Bereich eine zweiter Oberfläche aufweist und die Substratoberfläche gegenüber der zweiten Oberfläche zurückgesetzt ist;
- Bilden einer leitfähigen Struktur auf der Substratoberfläche neben dem isolierenden Bereich;
- Bilden einer isolierenden Schicht auf der Substratoberfläche und/oder dem isolierenden Bereich, wobei die leitfähige Struktur zumindest teilweise umhüllt wird;
- Planarisieren des isolierenden Bereichs, der isolierenden Schicht und der leitfähigen Struktur, wobei eine plane Oberfläche gebildet wird und ein Oberflächenbereich der leitfähigen Struktur freigelegt wird;
- Aufbringen einer metallhaltigen leitfähigen Schicht auf die plane Oberfläche;
- Strukturieren der metallhaltigen leitfähigen Schicht, wobei eine metallhaltige leitfähige Struktur auf der leitfähigen Struktur gebildet wird.

Die Lösung der bezüglich des Verfahrens beschreibt ein kostengünstiges Verfahren, mit dem beispielsweise das Gate eines Transistors mit einer niederohmigen metallischen Struktur versehen wird, wobei in vorteilhafter Weise der elektrische Widerstand des Gates reduziert wird. Ein weiterer Vorteil des erfindungsgemäßen Verfahrens besteht in der Planarisierung des isolierenden Bereichs, der isolierenden Schicht und der leitfähigen Struktur, wobei eine plane Oberfläche gebildet wird, durch die die Topographie der Oberfläche verringert wird.

In einer vorteilhaften Ausgestaltung der erfindungsgemäßen Anordnung ist auf dem isolierenden Bereich eine Stoppschicht für den Planarisierungsprozeß angeordnet. Die Stoppschicht hat den Vorteil, daß ein zur Planarisierung der Oberfläche durchgeführter Planarisierungsprozeß an der Stoppschicht beendet werden kann, wodurch die Höhe der planarisierten Oberfläche einstellbar ist.

Weiterhin ist es vorteilhaft, daß zwischen dem isolierenden Bereich und der Stoppschicht eine Zwischenschicht angeordnet ist. Die Zwischenschicht dient dazu, einen Abstand zwischen dem isolierenden Bereich und der Stoppschicht einzustellen. Damit kann in vorteilhafter Weise die Höhe der planarisierten Oberfläche oberhalb der Substratoberfläche eingestellt werden.

Ein vorteilhafter Verfahrensschritt sieht vor, daß das Planarisieren mit einem chemisch mechanischen Polierschritt durchgeführt wird. Dies hat den Vorteil, daß ein gut bekanntes und kontrollierbares Verfahren mit guter lokaler und globaler Planarisierung zur Planarisierung der Oberfläche verwendet wird.

Eine weitere vorteilhafte Ausgestaltung der Erfindung sieht vor, daß der isolierende Bereich als lokal oxidiertes Silizium mittels einer thermischen Oxidation in sauerstoffhaltiger Atmosphäre gebildet wird. Das Verfahren des lokal oxidierten Silizium (LOCOS) ist in der Halbleitertechnik ein bekanntes und kostengünstiges Verfahren zur Herstellung isolierender Bereiche, wodurch Einzelhalbleiter voneinander isoliert werden können.

Eine weitere vorteilhafte Ausgestaltung des erfindungsgemäßen Verfahren sieht vor, daß nach dem Planarisierungsschritt der freigelegte Oberflächenbereich der leitfähigen Struktur gereinigt wird. Die Reinigung des Oberflächenbereichs weist den Vorteil auf, daß ein niederohmiger elektrischer Kontakt zwischen der leitfähigen Struktur und der metallhaltigen leitfähigen Struktur hergestellt werden kann.

Weiterhin ist erfindungsgemäß vorgesehen, daß vor dem Bilden der isolierenden Schicht eine Stoppschicht auf dem isolierenden Bereich, der Substratoberfläche und der leitfähigen Struktur gebildet wird.

Weiterhin ist vorgesehen, daß die Stoppschicht zumindest teilweise von der Substratoberfläche und/oder der leitfähigen Struktur entfernt wird. Der Vorteil dieses Verfahrensschrittes besteht darin, daß bei dem Planarisieren der Oberfläche die Stoppschicht nicht von der leitfähigen Struktur entfernt werden muß, und daß die Stoppschicht nicht auf aktivem Gebiet angeordnet ist, welches an der Oberfläche des Substrats verläuft.

Weitere vorteilhafte Ausgestaltungen der Erfindung sind in den jeweiligen Unteransprüchen angegeben.

Die Erfindung wird nachfolgend anhand von Ausführungsbeispielen und Figuren näher erläutert.

In den Figuren zeigen:
- Figur 1: ein Substrat, auf dem ein isolierender Bereich und eine leitfähige Struktur angeordnet sind;
- Figur 2: die Anordnung aus Figur 1, wobei der isolierende Bereich und die leitfähige Struktur planarisiert sind und eine metallhaltige leitfähige Schicht auf der leitfähigen Struktur angeordnet ist;
- Figur 3: ein Substrat, auf dem ein isolierender Bereich und eine leitfähige Struktur angeordnet sind;
- Figur 4: die Anordnung aus Figur 3, wobei der isolierende Bereich und die leitfähige Struktur planarisiert sind und eine metallhaltige leitfähige Schicht auf den isolierenden Bereich und der leitfähigen Struktur angeordnet ist;
- Figur 5: die Anordnung aus Figur 1, wobei zusätzlich eine Stoppschicht auf dem isolierenden Bereich und der leitfähigen Struktur angeordnet ist;
- Figur 6: die Anordnung gemäß Figur 5, wobei die Anordnung eine plane Oberfläche aufweist, auf der eine metallhaltige leitfähige Struktur angeordnet ist;
- Figur 7: eine Anordnung gemäß Figur 5, wobei die Stoppschicht von der leitfähigen Struktur entfernt wurde;
- Figur 8: eine Anordnung gemäß Figur 7, wobei eine plane Oberfläche gebildet ist, auf der eine metallhaltige leitfähige Struktur angeordnet ist;
- Figur 9: eine Anordnung gemäß Figur 7, wobei zwischen dem isolierenden Bereich und der Stoppschicht eine Zwischenschicht angeordnet ist;
- Figur 10: eine Anordnung gemäß Figur 9, wobei auf einer planarisierten Oberfläche eine metallhaltige leitfähige Struktur angeordnet ist;
- Figur 11: einen Transistor, der auf einem Substrat 1 angeordnet ist.

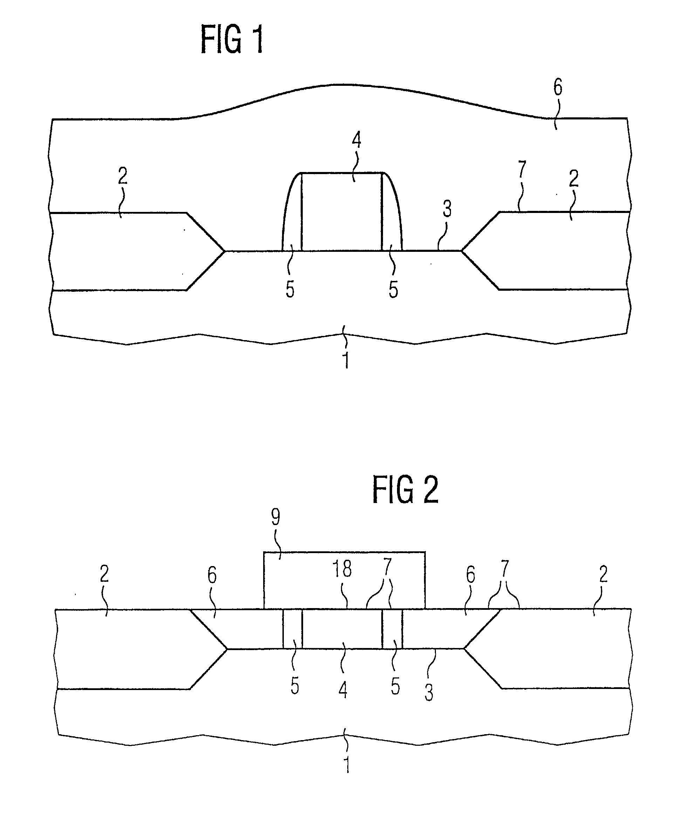

In Figur 1 ist ein Substrat 1 dargestellt, auf, bzw. in dem ein isolierender Bereich 2 angeordnet ist. Das Substrat 1 weist eine Substratoberfläche 3 auf, und der isolierende Bereich weist eine zweite Oberfläche 7 auf. Die Substratoberfläche 3 ist gegenüber der zweiten Oberfläche 7 zurückgesetzt, so daß der isolierende Bereich 2 zumindest teilweise über die Substratoberfläche 3 hinausragt. Das Substrat 1 ist beispielsweise aus Silizium gebildet, welches beispielsweise in einkristalliner Struktur vorliegen und dotiert sein kann. Die Oberfläche 3 des Substrats 1, die in Figur 1 zwischen den beiden isolierenden Bereichen 2 angeordnet ist, wird unter anderem als aktives Gebiet bezeichnet, da in diesem Bereich aktive Bauelemente wie Transistoren gebildet werden können. Weiterhin ist eine leitfähige Struktur 4 auf der Oberfläche 3 des Substrats 1 angeordnet. Beispielsweise kann es sich bei der leitfähigen Struktur 4 um eine Leiterbahn handeln, die aus polykristallinem Silizium gebildet sein kann. Ebenso ist es möglich, daß es sich bei der leitfähigen Struktur 4 um eine Gate-Elektrode handelt. Zusätzlich sind in Figur 1 seitliche Randstege 5 (Spacer) seitlich neben der leitfähigen Struktur 4 angeordnet. Spacer sind beispielsweise bei einer Source- oder Drain-Implantation dazu geeignet, eine LDD-(Lightly Doped Drain) und eine HDD- (Heavy Doped Drain) Implantation zu erzeugen. Weiterhin ist eine isolierende Schicht 6 auf dem isolierenden Bereich 2, der Substratoberfläche 3, den seitlichen Randstegen 5 und der leitfähigen Struktur 4 angeordnet. Die seitlichen Randstege 5 können beispielsweise aus Siliziumoxid oder Siliziumnitrid bestehen. Die isolierende Schicht 6 ist beispielsweise ein dotiertes Silikatglas, welches entsprechend mit Bor und/oder Phosphor dotiert ist.

Ein Verfahren zur Herstellung der in Figur 1 dargestellten Struktur bildet zunächst eine Maske auf der Oberfläche des Substrats 3, welche die aktiven Gebiete abdeckt. Eine anschließende thermische Oxidierung des Siliziumsubstrats bildet die isolierenden Bereiche 2 als LOCOS (Local Oxydised Silicon), die in der Siliziumhalbleiter-Herstellungstechnik wohl bekannt sind. Anschließend wird die Maske entfernt und nach entsprechenden Reinigungsschritten wird beispielsweise ein Gate-Oxid auf der Substratoberfläche 3 gebildet (hier nicht dargestellt). Anschließend wird eine Schicht bzw. Schichtenfolge auf der Oberfläche des Substrats gebildet, aus der die leitfähige Struktur 4 mittels eines Strukturierungsprozesses strukturiert wird. Hierzu sind beispielsweise anisotrope Ätzverfahren geeignet. Auch diese Verfahrensschritte sind für CMOS-Bauelemente übliche Verfahrensmerkmale. Nachfolgend werden Dotierungen und die seitlichen Radstege 5 (Spacer) gebildet, indem zunächst eine konforme Schicht abgeschieden wird, die anschließend mittels anisotroper Ätzung rückgeätzt wird. Dabei entstehen die seitlichen Randstege 5 angrenzend an der leitfähigen Struktur 4. Zur Bildung von Source- und Drain-Gebieten (hier nicht dargestellt) werden entsprechende Implantationsschritte durchgeführt, um Dotierstoff in das Substrat 1 - durch die Oberfläche 3 des Substrats 1 hindurch - einzubringen. Anschließend wird die isolierende Schicht 6 mittels Abscheidung eines dotierten Silikatglases gebildet. Dotierte Silikatglase weisen den Vorteil auf, daß sie bereits bei Temperaturen um ca. 400° C fließfähig sind und somit dazu geeignet sind, Höhenunterschiede auf einer Oberfläche auszugleichen.

In Figur 2 ist eine Weiterbildung der in Figur 1 dargestellten Anordnung gezeigt. Ausgehend von Figur 1 wird ein CMP-Schritt (Chemisches, Mechanisches Polieren) durchgeführt, bei dem zunächst die isolierende Schicht 6 planarisiert und abgetragen wird, und wobei zusätzlich die leitfähige Struktur 4 sowie die seitlichen Randstege 5 abgetragen und poliert werden, bis eine plane Oberfläche 7 entstanden ist, die eine Ebene einschließlich des isolierenden Bereichs 2, der isolierenden Schicht 6, des seitlichen Randstegs 5 und der leitfähigen Struktur 4 bildet. Als CMP-Stoppschicht wird der isolierende Bereich 2 verwendet. Wie aus Figur 2 ersichtlich ist, stoppt der CMP-Prozeß auf dem isolierenden Bereich 2, wobei zwischen den beiden isolierenden Bereichen 2 ein unterer Teil der ursprünglichen leitfähigen Struktur 4, der seitlichen Randstege 5 und der isolierenden Schicht 6 bestehen bleibt. Vorteilhafterweise wird dabei die leitfähige Struktur 4 freigelegt. Für den Fall, daß die isolierende Schicht 6 aus BPSG mit einem Bor-Anteil von 4% und einem Phosphoranteil von ebenfalls 4% gebildet ist, so ist die Abtragsrate der isolierenden Schicht 6 etwa 3,3 (Selektivität)mal so hoch wie die Abtragsrate des isolierenden Bereichs 2, der aus thermischem Siliziumoxid besteht. Praktisch gut umsetzbar sind Verfahren bereits ab Selektivitäten um 2. Typische Selektivitäten liegen zwischen 3 und 5. Dies bedeutet, daß eine ausreichende Selektivität zum Stoppen des CMP-Prozesses auf dem isolierenden Bereich 2 vorhanden ist. Darüber hinaus kann in einem Ausführungsbeispiel die Oberfläche des isolierenden Bereichs 2 wesentlich größer gebildet werden als die Oberfläche 3 des aktiven Gebiets. Dadurch ist sichergestellt, daß der CMP-Prozeß auf dem isolierenden Bereich 2 stoppt. Zusätzlich werden durch den CMP-Prozeß Strukturen entfernt, die auf dem isolierenden Bereich 2 angeordnet sind. Beispielsweise werden dabei auf dem isolierenden Bereich 2 verlaufende Leiterbahnen aus Polysilizium entfernt, die über die Kante des isolierenden Bereichs 2 verlaufen. Durch den CMP-Prozeß ist der Oberflächenbereich 18 der leitfähigen Struktur 4 freigelegt. Optional können nun Reinigungsschritte vorgenommen werden, die zur Erzielung eines guten elektrischen Kontaktes zwischen der leitfähigen Struktur 4 und einer darauf angeordneten metallhaltigen leitfähigen Struktur 9 geeignet sind. Anschließend wird eine metallhaltige leitfähige Schicht auf der planen Oberfläche 7 abgeschieden und mittels eines anisotropen Ätzschrittes und einer Ätzmaske strukturiert. Dabei wird eine metallhaltige leitfähige Struktur 9 gebildet, die auf der leitfähigen Struktur 4 angeordnet ist. Die metallhaltige leitfähige Schicht kann beispielsweise als Schichtstapel - ausgehend von der leitfähigen Struktur 4 - bestehend aus Titan, Titannitrid, Aluminium - mit einer Silizium- und/oder Kupfer-Dotierung, Titan und Titannitrid gebildet werden. Weiterhin ist es möglich, daß die metallhaltige leitfähige Schicht die Materialien Wolfram, Wolframnitrid, Kupfer, Tantal oder Tantalnitrid enthält. Die metallhaltige leitfähige Struktur 9 hat den Vorteil, daß die Anordnung bestehend aus leitfähiger Struktur 4 und metallhaltiger leitfähiger Struktur 9 einen wesentlich niedrigeren Leitungswiderstand aufweist als die leitfähige Struktur 4 für sich allein betrachtet. Im Gegensatz zu dem in der Beschreibungseinleitung beschriebenen Stand der Technik vermeidet die erfindungsgemäße Anordnung die Nachteile einer erhöhten Gate-Kapazität und einer verringerten Packungsdichte sowie den Nachteil von erhöhten Prozeßkosten. Die Strukturierung der metallhaltigen leitfähigen Schicht wird beispielsweise mittels eines RIE-Schrittes (Reactive Ion Etch) durchgeführt. Optional kann auf die metallhaltige leitfähige Schicht eine Antireflexschicht aufgebracht werden, die zu verbesserten Belichtungsergebnissen für die Strukturierung der metallhaltigen leitfähigen Struktur 9 führt.

Der CMP-Schritt wird mit einem alkalischen Slurrey (Poliermittel) durchgeführt, Silica-basiert (Silica-Emulsion mit Siliziumoxid-Partikeln) ist. Bei der verwendeten Maschine handelt es sich um eine kommerziell erhältliche Standartmaschine.

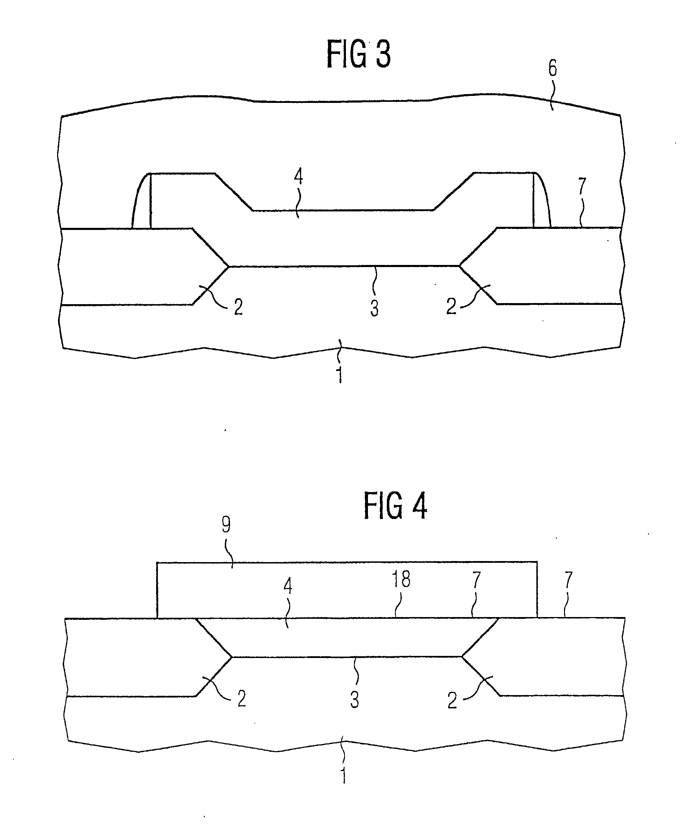

In Figur 3 ist eine Anordnung dargestellt, die ebenfalls mit den Schritten zur Bildung der in Figur 1 dargestellten Struktur hergestellt werden kann. In Figur 3 ist beispielsweise ein Schnitt entlang eines Polysilizium-Gates dargestellt, der in Richtung der Kanalweite verläuft. Der Unterschied zu Figur 1 besteht darin, daß die leitfähige Struktur 4 nicht nur auf der Oberfläche 3 des Substrats 1 angeordnet ist, sondern ebenfalls auf dem isolierenden Bereich 2 verläuft.

Mit Bezug auf Figur 4 ist der oben beschriebene CMP-Prozeß durchgeführt worden, wobei eine plane Oberfläche 7 von dem isolierenden Bereich 2 und der leitfähigen Struktur 4 gebildet ist. Anschließend ist die metallhaltige leitfähige Schicht auf dem isolierenden Bereich 2 und der leitfähigen Struktur 4 angeordnet worden. Die metallhaltige leitfähige Schicht ist mittels eines Ätzschrittes strukturiert worden, so daß die metallhaltige leitfähige Struktur 9 auf der leitfähigen Struktur 4 und auf dem isolierenden Bereich 2 gebildet ist.

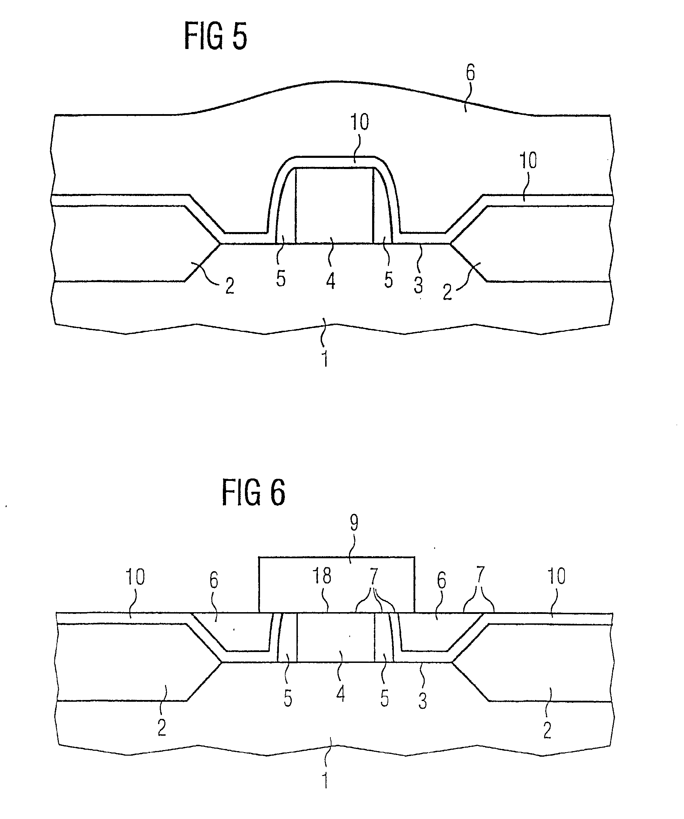

Eine weitere Verfahrensvariante des erfindungsgemäßen Verfahrens ist in Figur 5 dargestellt. Figur 5 unterscheidet sich von Figur 1 darin, daß eine Stoppschicht 10 auf dem isolierenden Bereich 2, der Oberfläche 3 des Substrats 1 und der leitfähigen Struktur 4 angeordnet ist. Hergestellt wird die Stoppschicht 10 vor der Abscheidung der isolierenden Schicht 6, indem eine konforme Schicht 10 auf die freiliegende Oberfläche aufgebracht wird. Beispielsweise besteht die Stoppschicht 10 aus Siliziumnitrid. Eine Siliziumnitridschicht weist den Vorteil auf, daß die Abtragsrate während des CMP-Prozesses für ein dotiertes Silikatglas zwischen 5 und 15 und typische 9 Mal größer ist als für Siliziumnitrid. Folglich ist die Siliziumnitridschicht in vorteilhafter Weise als Stoppschicht für den CMP-Prozeß geeignet. Aus Figur 5 ist ersichtlich, daß die Stoppschicht 10 ebenfalls auf der leitfähigen Struktur 4 angeordnet ist und dort über die Höhe der Stoppschicht 10 auf dem isolierenden Bereich 2 hinausragt, die auf dem isolierenden Bereich 2 angeordnet ist.

In Figur 6 ist dargestellt, daß die Stoppschicht 10, die auf der leitfähigen Struktur 4 angeordnet war, den CMP-Prozeß nicht beendet, da der Flächenanteil der leitfähigen Struktur 4 im Vergleich zu dem Flächenanteil der isolierenden Bereiche 2 sehr gering ist. Folglich führt diese Fläche nicht zwangsläufig zu einem Ätzstopp. Daher wird die Stoppschicht 10 von der leitfähigen Struktur 4 entfernt, wodurch die leitfähige Struktur 4 in einem Oberflächenbereich 18 freigelegt wird. Dieses Vorgehen ist bei CMP-Prozessen als lokal reduzierte Selektivität bekannt. Die Bildung der metallhaltigen leitfähigen Schicht und der metallhaltigen leitfähigen Struktur 9 erfolgt, wie es im Zusammenhang mit Figur 1 und 2 beschrieben wurde. Die nach dem CMP-Prozeß verbleibende Stoppschicht 10 kann als eine zusätzliche Diffusionsbarriere für Metallionen und Verunreinigung wirken. Die Stoppschicht 10 wird beispielsweise mit einer Dicke zwischen 50 und 100 nm gebildet. Die Siliziumnitridschicht kann mit einem PVD (Physical Vapour Depositio: Sputtern), LPCVD (Low Pressure Chemical Vapour Deposition: niederdruck-Dampfabscheideverfahren) oder PECVD (Plasma Enhanced Chemical Vapour Deposition: Plasmaunterstütztes CVD) hergestellt werden. Weiterhin ist als Stoppschicht 10 eine Siliziumcarbidschicht geeignet sowie oxidiertes Siliziumcarbid und Kohlenstoffdotiertes Siliziumoxid.

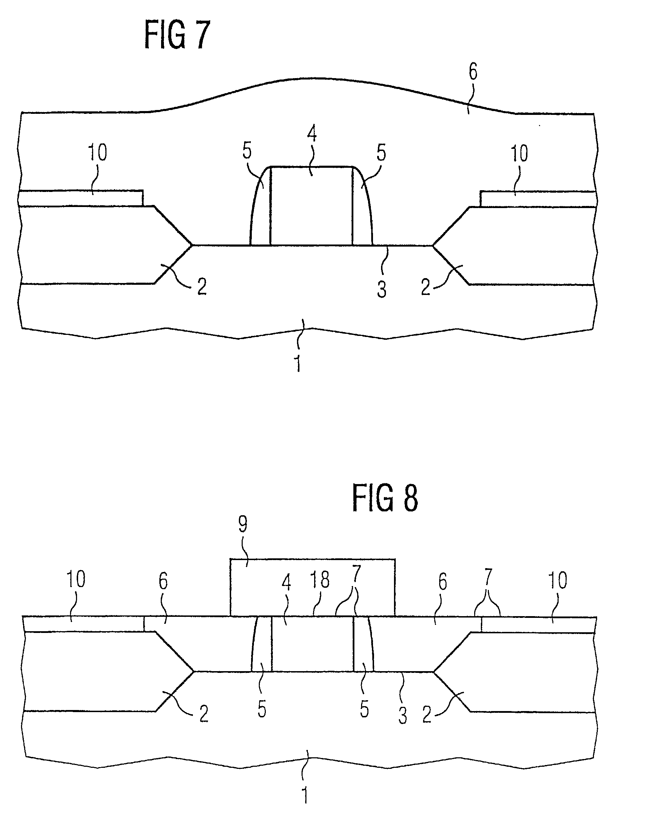

Mit Bezug auf Figur 7 wird eine weitere Variante der erfindungsgemäßen Anordnung und des erfindungsgemäßen Verfahrens beschrieben. Figur 7 unterscheidet sich von Figur 5 darin, daß die zunächst konform abgeschiedene Stoppschicht 10 nachfolgend strukturiert wird. Dazu wird die Stoppschicht 10 von einem Teil des isolierenden Bereichs 2, von der Oberfläche 3 des Substrats 1 sowie der leitfähigen Struktur 4 entfernt. Die Strukturierung der Stoppschicht 10 hat den Vorteil, daß die Stoppschicht 10 nicht auf dem aktiven Gebiet angeordnet ist, welches sich unterhalb der Oberfläche 3 des Substrats 1 befindet. Weiterhin ist eine spätere Kontaktlochätzung durch die Siliziumnitridschicht schwieriger, als durch BPSG, so daß das Entfernen der Siliziumnitridschicht vorteilhaft ist. Darüber hinaus weist Siliziumnitrid eine höhere Dielektrizitätskonstante als Siliziumoxid auf, so daß hohe parasitäre Kapazitäten vermieden werden. Weiterhin ist eine Grenzfläche zwischen Silizium und Siliziumnitrid verspannt, was eine zusätzliche Zwischenschicht aus Siliziumoxid erforderlich machen kann. Weiterhin ist vorteilhaft, daß die Stoppschicht 10 von den seitlichen Randstegen 5 entfernt wird, da sich an dieser Stelle sonst Verunreinigungen an der Grenzfläche zwischen den Materialien Silizium und Siliziumnitrid bzw. Siliziumnitrid und Siliziumoxid sammeln können. Besagte Grenzfläche ist in unmittelbarer Nähe eines Kanals eines MOS-Transistors angeordnet, wodurch der Transistor beschädigt werden kann. Ein Verfahren zur Herstellung der strukturierten Stoppschicht 10 in Figur 7 sieht zunächst die konforme Abscheidung der Stoppschicht 10 vor, wobei anschließend mittels einer Phototechnik die zu entfernenden Teile der Stoppschicht 10 freigelegt werden und beispielsweise mittels eines reaktiven Ionenätzschrittes oder mittels naßchemischen Ätzens entfernt werden. Zur Entfernung von Siliziumnitrid ist beispielsweise eine naßchemische Ätzung mit Phosphorsäure (H₃PO₄) geeignet.

Mit Bezug auf Figur 8 werden die nun nachfolgenden Verfahrensschritte zur Herstellung der metallhaltigen leitfähigen Struktur 9 durchgeführt, wie sie bereits im Zusammenhang mit den vorhergehenden Figuren beschrieben worden sind.

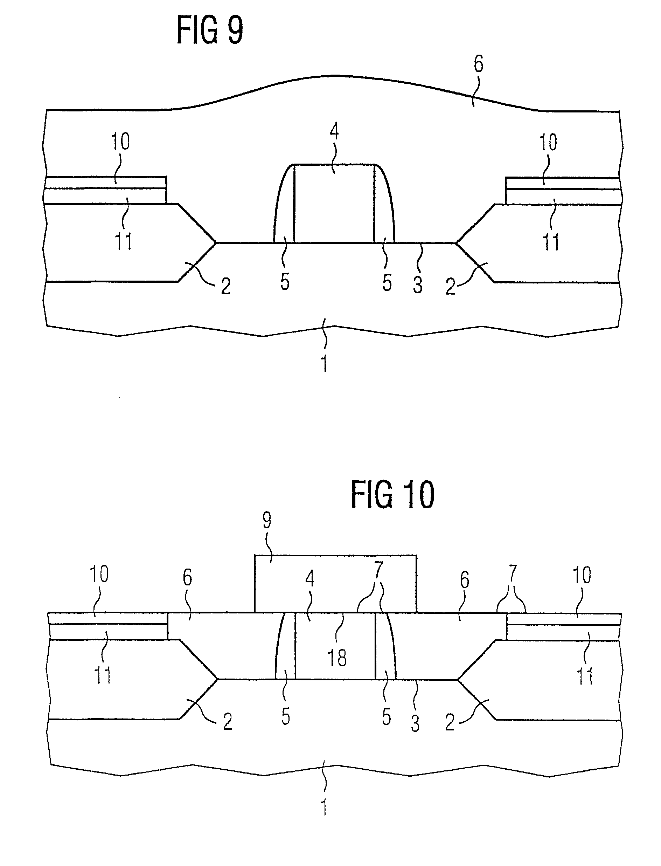

Mit Bezug auf Figur 9 wird nun eine weitere Ausgestaltung der Erfindung beschrieben. Die in Figur 9 dargestellte Anordnung unterscheidet sich von Figur 7 dahingehend, daß zwischen dem isolierenden Bereich 2 und der strukturierten Stoppschicht 10 eine Zwischenschicht 11 angeordnet ist. Die Zwischenschicht 11 ist in vorteilhafter Weise dazu geeignet, einen definierten Abstand zwischen der Oberfläche der Stoppschicht 10 und der Substratoberfläche 3 einzustellen. Dieser Abstand bildet nach dem CMP-Schritt später die Höhe der leitfähigen Struktur 4, auf der die metallhaltige leitfähige Struktur 9 angeordnet wird. Ein weiterer Vorteil der Zwischenschicht 11 besteht darin, daß durch den definierten Abstand der metallhaltigen leitfähigen Struktur 9 und dem Substrat 1 die zwischen diesen beiden Schichten bestehende Kapazität mittels der Zwischenschicht 11 einstellbar ist. Ein weiterer Vorteil besteht darin, daß die nach dem CMP-Schritt verbleibende Dicke der leitfähigen Struktur 4 nicht mehr von der Höhe des isolierenden Bereichs 2 beschränkt ist, sondern mittels der Zwischenschicht 11 frei wählbar ist. Die Zwischenschicht 11 ist beispielsweise aus Siliziumoxid gebildet. Mit zunehmender Dicke der zusätzlichen Zwischenschicht 11 wird während des CMP-Schrittes immer weniger von der leitfähigen Struktur 4 abgetragen. Die Zwischenschicht 11 wird beispielsweise als konforme Abscheidung aufgebracht, bevor die Stoppschicht 10 abgeschieden wird. Nach dem CMP-Schritt beträgt die verbleibende Gate-Höhe z.B. 110 nm. Mit der zusätzlichen Zwischenschicht beträgt die Restdicke der leitfähigen Struktur 4 nach dem CMP-Schritt z.B. 330 nm. Auch andere Höhen der verbleibenden Gate-Höhe sind möglich.

Mit Bezug auf Figur 10 ist der bereits in Zusammenhang mit den Figuren von 1 bis 9 beschriebene CMP-Prozeß durchgeführt worden und der Oberflächenbereich 18 der leitfähigen Struktur 4 freigelegt worden. Oberhalb der leitfähigen Struktur 4 ist die metallhaltige leitfähige Struktur 9 angeordnet.

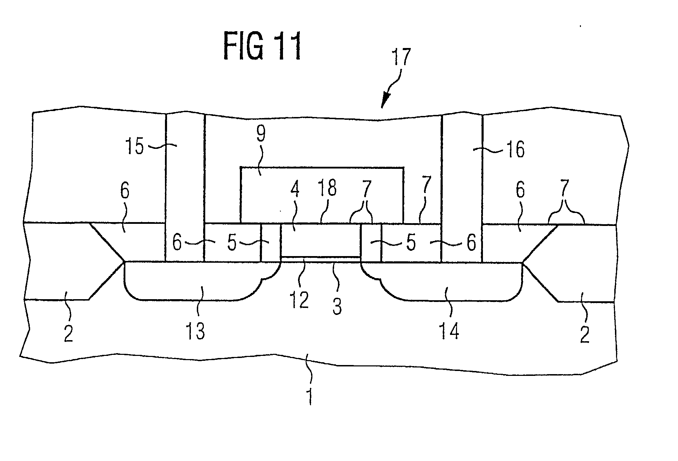

In Figur 11 ist ein Transistor 17 dargestellt, der auf einem Substrat 1 gebildet ist. Der Transistor 17 ist in dem aktiven Bereich zwischen den beiden isolierenden Bereichen 2 angeordnet. Auf der Oberfläche 3 des Substrats 1 ist ein Gate-Oxid 12 gebildet, auf dem eine leitfähige Struktur 4 angeordnet ist. Bei der leitfähigen Struktur 4 handelt es sich beispielsweise um eine Gate-Elektrode. Seitlich benachbart an der Gate-Elektrode sind zwei seitliche Randstege 5 angeordnet. Neben den seitlichen Randstegen 5 sind isolierende Schichten 6 angeordnet. Der isolierende Bereich 2, die leitfähige Struktur 4 und die isolierende Schicht 6 besitzen eine gemeinsame plane Oberfläche 7, die mittels eines CMP-Schrittes hergestellt wurde. Seitlich neben der leitfähigen Struktur 4 und den seitlichen Randstegen 5 ist ein Source-Gebiet 13 und ein Drain-Gebiet 14 angeordnet. Das Source-Gebiet 13 ist mittels eines Source-Anschlusses 15 und das Drain-Gebiet 14 mittels eines Drain-Anschlusses 16 kontaktiert.

### Bezugszeichenliste

- 1: Substrat
- 2: isolierender Bereich
- 3: Oberfläche des Substrats
- 4: leitfähige Struktur
- 5: seitlicher Randsteg
- 6: isolierende Schicht
- 7: plane Oberfläche
- 9: metallhaltige leitfähige Struktur
- 10: Stoppschicht
- 11: Zwischenschicht
- 12: Gate-Oxid
- 13: Source-Gebiet
- 14: Drain-Gebiet
- 15: Source-Anschluß
- 16: Drain-Anschluß
- 17: Transistor
- 18: Oberflächenbereich

## Patentansprüche

1. Halbleiterbauelement mit einer leitfähigen Struktur, umfassend:
- ein Substrat (1) mit einer Substratoberfläche (3) und einem isolierenden Bereich (2), der eine zweite Oberfläche (7) aufweist, wobei die Substratoberfläche (3) gegenüber der zweiten Oberfläche (7) zurückgesetzt ist;
- eine leitfähige Struktur (4), die neben dem isolierenden Bereich (2) auf der Substratoberfläche (3) angeordnet ist;
- eine isolierenden Schicht (6), die auf der Substratoberfläche (3) angeordnet ist und die leitfähige Struktur (4) zumindest teilweise umgibt und wobei der isolierende Bereich (2), die isolierende Schicht (6) und die leitfähige Struktur (4) eine plane Oberfläche (7) bilden;
- eine metallhaltige leitfähigen Struktur (9), die auf der planen Oberfläche (7) oberhalb der leitfähigen Struktur (4) angeordnet ist.

2. Halbleiterbauelement nach Anspruch 1,
**dadurch gekennzeichnet, daß**
auf dem isolierenden Bereich (2) eine Stoppschicht (10) für den Planarisierungsprozeß angeordnet ist.

3. Halbleiterbauelement nach Anspruch 2,
**dadurch gekennzeichnet, daß**
die Stoppschicht (10) auf der leitfähigen Struktur (4) angeordnet ist.

4. Halbleiterbauelement nach einem der Ansprüche 1 bis 3,
**dadurch gekennzeichnet, daß**
zwischen dem isolierenden Bereich (2) und der Stoppschicht (10) eine Zwischenschicht (11) angeordnet ist.

5. Halbleiterbauelement nach einem der Ansprüche 1 bis 4,
**dadurch gekennzeichnet, daß**
auf der Substratoberfläche (3) angrenzend an die leitfähige Struktur (4) ein seitlicher Randsteg (5) angeordnet ist.

6. Halbleiterbauelement nach einem der Ansprüche 1 bis 5,
**dadurch gekennzeichnet, daß**
die leitfähige Struktur (4) ein Gate eines Transistors (17) ist und polykristallines, dotiertes Silizium enthält.

7. Halbleiterbauelement nach einem der Ansprüche 1 bis 6,
**dadurch gekennzeichnet, daß**
die metallhaltige leitfähige Struktur (9) Titan, Titannitrid, Aluminium, Silizium, Kupfer, Tantal, Tantalnitrid, Wolfram oder Wolframnitrid enthält.

8. Halbleiterbauelement nach einem der Ansprüche 1 bis 7,
**dadurch gekennzeichnet, daß**
die metallhaltige leitfähige Struktur (9) einen Schichtstapel aus Titan; Titannitrid; Aluminium Silizium Kupfer; Titannitrid und Titan umfaßt.

9. Halbleiterbauelement nach einem der Ansprüche 1 bis 8,
**dadurch gekennzeichnet, daß**
das Substrat (1) Silizium, die leitfähige Struktur (4) Polysilizium, der isolierende Bereich (2) Siliziumoxid, die isolierende Schicht (6) dotiertes Silikatglas, die Stoppschicht (10) Siliziumnitrid oder die Zwischenschicht (11) Siliziumoxid enthält.

10. Halbleiterbauelement nach einem der Ansprüche 1 bis 9,
**dadurch gekennzeichnet, daß**
die metallhaltige leitfähige Struktur (9) einen an die leitfähige Struktur (4) angrenzenden Bereich der planen Oberfläche (7) überlappt.

11. Verfahren zur Herstellung eines Halbleiterbauelements mit einer leitfähigen Struktur mit den Schritten:
- Bilden eines isolierenden Bereichs (2) auf einem Substrat (1), wobei das Substrat (2) eine Substratoberfläche (3) und der isolierende Bereich (2) eine zweiter Oberfläche (7) aufweist und die Substratoberfläche (3) gegenüber der zweiten Oberfläche (7) zurückgesetzt ist;
- Bilden einer leitfähigen Struktur (4) auf der Substratoberfläche (3) neben dem isolierenden Bereich (2);
- Bilden einer isolierenden Schicht (6) auf der Substratoberfläche (3) und/oder dem isolierenden Bereich (2), wobei die leitfähige Struktur (4) zumindest teilweise umhüllt wird;
- Planarisieren des isolierenden Bereichs (2), der isolierenden Schicht (6) und der leitfähigen Struktur (4), wobei eine plane Oberfläche (7) gebildet wird und ein Oberflächenbereich (18) der leitfähigen Struktur (4) freigelegt wird;
- Aufbringen einer metallhaltigen leitfähigen Schicht auf die plane Oberfläche (7);
- Strukturieren der metallhaltigen leitfähigen Schicht, wobei eine metallhaltige leitfähige Struktur (9) auf der leitfähigen Struktur (4) gebildet wird.

12. Verfahren nach Anspruch 11,
**dadurch gekennzeichnet, daß**
das Planarisieren mit einem chemischen, mechanischen Polierschritt durchgeführt wird.

13. Verfahren nach einem der Ansprüche 11 oder 12,
**dadurch gekennzeichnet, daß**
der isolierende Bereich (2) als lokal oxidiertes Silizium mittels einer thermischen Oxidation in sauerstoffhaltiger Atmosphäre gebildet wird.

14. Verfahren nach einem der Ansprüche 11 bis 13,
**dadurch gekennzeichnet, daß**
nach dem Planarisierungsschritt der freigelegte Oberflächenbereich (18) der leitfähigen Struktur (4) gereinigt wird.

15. Verfahren nach einem der Ansprüche 11 bis 14,
**dadurch gekennzeichnet, daß**
vor dem Bilden der isolierenden Schicht (6) eine Stoppschicht (10) auf dem isolierenden Bereich (2), der Substratoberfläche (3) und der leitfähigen Struktur (4) gebildet wird.

16. Verfahren nach Anspruch 15,
**dadurch gekennzeichnet, daß**
die Stoppschicht (10) zumindest teilweise von der Substratoberfläche (3) und/oder der leitfähigen Struktur (4) entfernt wird.

17. Verfahren nach einem der Ansprüche 15 oder 16,
**dadurch gekennzeichnet, daß**
vor dem Bilden der Stoppschicht (10) eine Zwischenschicht (11) auf dem isolierenden Bereich (2), der Substratoberfläche (3) und der leitfähigen Struktur (4) gebildet wird.
